Europäisches Patentamt

European Patent Office

Office européen des brevets

(19)

(11) Publication number: **0 074 541**
**B1**

# EUROPEAN PATENT SPECIFICATION

(45) Date of publication of patent specification: **01.03.89**

(21) Application number: **82107889.6**

(22) Date of filing: **27.08.82**

(51) Int. Cl.⁴: **H 01 L 21/76, H 01 L 21/324,
H 01 L 21/90**

(54) Method for the production of a semiconductor device comprising dielectrically isolating regions.

(30) Priority: **10.09.81 JP 142911/81**

(43) Date of publication of application:
**23.03.83 Bulletin 83/12**

(45) Publication of the grant of the patent:
**01.03.89 Bulletin 89/09**

(84) Designated Contracting States:
**DE FR GB**

(56) References cited:
**DE-A-3 023 410**
**US-A-4 069 577**
**US-A-4 181 537**
**US-A-4 282 647**
**IBM TECHNICAL DISCLOSURE BULLETIN, vol.
23, no. 8, January 1981 New York, US D.W.
ORMOND: "Method of manufacturing
dielectrically isolated regions of silicon
utilizing high pressure steam", pages 3694-
3697**
**IBM TECHNICAL DISCLOSURE BULLETIN, vol.
21, no. 7, December 1978 New York, US H.B.
POGGE: "Single mask self-aligned trench
isolation/diffusion process", pages 2734-2735**

(73) Proprietor: **FUJITSU LIMITED**
**1015, Kamikodanaka Nakahara-ku
Kawasaki-shi Kanagawa 211 (JP)**

(72) Inventor: **Ogawa, Tetsuya
Fujinodai-danchi 1-17-207, 3486 Honmachida
Machida-shi Tokyo 194 (JP)**
Inventor: **Toyokura, Nobuo
1569-1, Shinsaku Takatsu-ku
Kawasaki-shi Kanagawa 213 (JP)**

(74) Representative: **Sajda, Wolf E., Dipl.-Phys. et al
MEISSNER, BOLTE & PARTNER
Widenmayerstrasse 48 Postfach 86 06 24
D-8000 München 86 (DE)**

## Description

The present invention relates to methods for the production of semiconductor devices, and more specifically to an improvement applicable to methods for the production of buried insulating layers each of which surrounds a portion of a semiconductor substrate, in which elements are fabricated, the buried insulating layer functioning to isolate each element fabricated in a chip from one another.

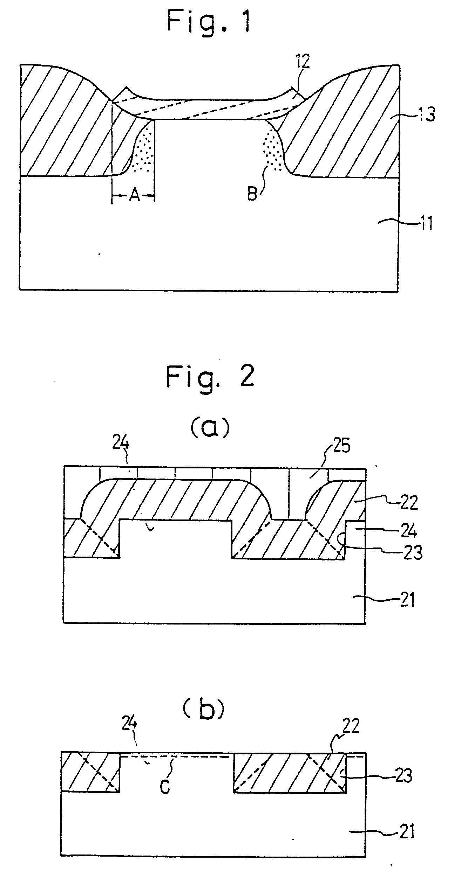

A tendency is recognized in which the dimension of each element is being decreased to satisfy requirements for a larger quantity of elements fabricated in a chip and also for a larger quantity of elements fabricated in the unit areas of a chip, such requirements being included in the requirements effective to satisfy the ultimate purposes for development of LSI-s and further of VLSI-s. Insofar, as the purposes to isolate each element fabricated in one chip from one another are concerned, a process which is called local oxidation of silicon is available, and it is well-known that this process has various advantages in the aspects of an easy production of durable wirings which are free from potential discontinuation thereof and of potential employment of self-alignment and the like. However, this local oxidation process is involved with drawbacks pointed out below. The first is the problem of bird's beak. Referring to Fig. 1, local oxidation of the top surface of a silicon (Si) substrate 11 of which a limited area is covered by a silicon nitride ($Si_3N_4$) layer mask 12 is accompanied by lateral growth of a silicon dioxide ($SiO_2$) layer 13. This lateral growth produces a silicon dioxide ($SiO_2$) layer having a bird's beak shape which extends toward under the silicon nitride ($Si_3N_4$) layer 12. The lateral length A of this bird's beak causes a less grade of dimensional accuracy. The second is the problem of strain which is produced in the portion B of the silicon substrate 11, the portion B directly contacting with the layer 13 of silicon dioxide ($SiO_2$) which is converted from silicon (Si) during the oxidation process which inevitably causes expansion in volume of the nitride. This strain appearing in the silicon (Si) layer B can be a parameter to cause unsatisfied characteristics for elements fabricated in the silicon (Si) layer. The third is the problem of white ribbon. Since it is not necessarily easy to entirely remove the silicon nitride ($Si_3N_4$) layer 12, numerous minute particles of the nitride remain on the surface of the silicon (Si) substrate 11 in the form of scattered stains. These residual nitride particles function as a type of mask during the oxidation processes carried out in later steps.

The above description means that the local oxidation process is not necessarily satisfactory for the production of a semiconductor device having minute patterns. For the purpose to remove the foregoing drawbacks, a method wherein each element is isolated from one another by buried insulating layers which are grown to fill grooves produced along the surface of a silicon (Si) substrate to surround each element, has been developed and is prevailingly employed. Unfortunately, however, this improved method is involved with other drawbacks described below, referring to the drawings.

Depending on the etching process employed, an "in-house" method is classified into two independent categories.

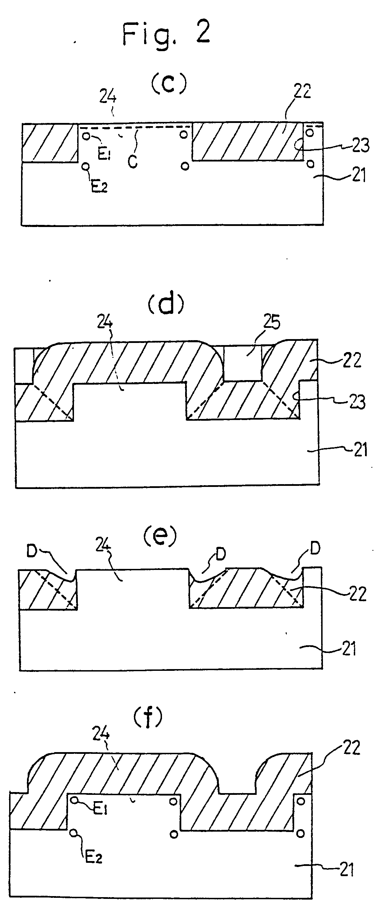

The first is the case wherein a dry etching process is employed. Referring to Fig. 2(a), the first step is to employ a chemical vapor deposition process for the purpose to grow an insulating layer 22 of a silicon (Si) substrate 21 which is provided with grooves 23 surrounding mesa shaped portions 24 in which elements are scheduled to be fabricated, before a photoresist layer 25 is coated on the uneven surface of the insulating layer 22. As a result, the top surface of the photoresist layer 25 becomes flat. Referring to Fig. 2(b), the second step is to employ a dry etching process which has a single etching rate regardless of the quality of the material to be etched, to the substrate 21 covered by the insulating layer 22 and by the photoresist layer 25. As a result, the insulating layer 22 remains exclusively in the groove 23, and the top surface of the silicon (Si) substrate 21 becomes uncovered. During this process, however, the ion beams employed for the dry etching process readily produce damages C along the top surface of the mesa shaped portion 24 of the silicon (Si) substrate 21 in which elements are scheduled to be fabricated. These damages readily cause a less satisfactory grade of characteristics for elements fabricated in this substrate 21. It is quite natural that the silicon (Si) substrate must be exposed to a plurality of high temperature processes such as oxidation, annealing for curing damages caused by application of ion implantation processes and the like, during later processes for production of elements therein. Referring to Fig. 2(c), since the foregoing high temperature processes are involved with non-uniform variation of density of the insulating layer 22, this variation causes strains $E_1$ and/or $E_2$ to occur at the corners of the mesa shaped portion 24 of the substrate 21 surrounded by the buried insulating layer 22. These strains are also parameters for causing a less grade of characteristics of elements fabricated in this substrate 21.

The second is the case wherein a wet etching process is employed. Referring to Fig. 2(d), the first step is to employ a dry etching process to remove the photoresist layer 25 from the areas on which elements are scheduled to be fabricated, remaining the photoresist layer 25 exclusively along the grooves. Referring to Fig. 2(e), the second step is to employ a wet etching process to remove the insulating layer 22 from the areas on which elements are scheduled to be fabricated, remaining the insulating layer 22 exclusively in the groove 23. Since the groove 23 has sharp corners at the bottom and top edges, the density of the insulating layer 22 can not be entirely uniform and the density thereof turns out to be less along the broken lines shown in each of the Figs. 2(a), (b), (d), and (e) than in the other regions. Since a material having a less amount of density has a larger amount of etching rate, recesses D are produced along the edges of the insulating layer 22 which is buried in the silicon (Si) substrate 21. As a result, the surface of a chip can not be flat, causing possibilities of discontinuation and/or dimensional errors for wires which are placed along the silicon (Si) substrate 21.

For the purpose to prevent the occurrence of the foregoing recesses D along the edges of the insulating layer 22, an annealing process is ordinarily employed after the completion of the insulating layer 22. Albeit this annealing process is effective to unify the density of the insulating layer 22 even in the portions along the broken lines shown in Fig. 2, a difference in the amount of the coefficient of expansion between that for the material of the substrate and that for the material of the insulating layer causes stresses to occur along the interfaces of both the materials, since the stresses concentrate along the edges. As a result, strains $E_1$ and/or $E_2$ occur along the edges of the element fabrication areas of the substrate 21 surrounded by the buried insulating layer 22 in Fig. 2(f). These strains are also parameters for causing a less grade of characteristics of elements fabricated in this substrate 21.

From the publication IBM Disclosure Bulletin, Vol. 21, No. 7, December 1978, pages 2734—2735, entitled "Single mask self-aligned trench isolation/diffusion process" by H. B. Pogge, a method for the production of a semiconductor device is known wherein an initial structure comprises a silicon substrate covered by a silicon dioxide layer on which a polysilicon layer is formed which in turn is covered by a silicon nitride layer. By photolithography and etching techniques the desired pattern is formed in the silicon nitride layer, and the polysilicon layer is thermally oxidized in a suitable ambient to form a silicon dioxide layer. Then, a block-off photoresist mask is used to protect designated device areas, and silicon dioxide is removed in designated areas to be isolation areas.

Thereafter, trenches are produced by reactive ion etching. These trenches are filled by chemical vapor deposited silicon dioxide which overlays the entire surface. This step is followed by a planarizing resist application. Reactive ion etching of this planar surface back to the polysilicon layer removes the unwanted overlay of silicon dioxide layer and leaves the filled trenches. The remaining polysilicon layer together with the silicon dioxide layer thereunder are removed to expose the silicon areas for the diffusion of impurities to form the source-drain regions of a FET.

Accordingly, in this prior art method impurities are diffused by thermal processing after the polysilicon layer has been removed. Therefore, the polysilicon layer used in this known method is not disclosed to be a thermal strain absorbing layer.

An object of the present invention is to provide a method for the production of a semiconductor device having a plurality of elements each of which is isolated from one another by buried insulating layers, wherein an improvement is made (a) to prevent strains $E_1$ which may otherwise occur along the top edges of the element fabrication areas of a semiconductor substrate surrounded by buried insulating layers which function to isolate each element from one another, from occurring during an annealing process which is carried out to unify the density of the insulating layer, (b) to decrease the amount of strains $E_2$ which occur along the bottom edges of the element fabrication areas of the semiconductor substrate surrounded by buried insulating layers which function to isolate each element from one another, during the annealing process which is carried out to unify the density of the insulating layer, and (c) to prevent damages C which may otherwise be produced along the element fabrication areas of a semiconductor substrate surrounded by buried insulating layers, from being produced during a dry etching process which is carried out to remove a part of the insulating layer which is grown on the semiconductor substrate, remaining the other part of the insulating layer in grooves surrounding the element fabrication areas of the semiconductor substrate, the remained part of the insulating layer being the buried insulating layer which functions as isolation.

Another object of the present invention is to provide a method for the production of a semiconductor device having a plurality of elements each of which has a satisfying quality due to the lack of damages in the element fabrication areas of the semiconductor substrate surrounded by buried insulating layers which function to isolate each element from one another, wherein an improvement is made to simplify the steps for the production of wirings.

The above problem is solved by a method for the production of a semiconductor device according to the invention, comprising a step to grow a thermal strain absorbing layer on the top surface of a substrate comprising a semiconductor, an etching step to remove selectively the thermal strain absorbing layer and produce in the exposed portion of the substrate a groove surrounding a mesa-shaped portion of the substrate where a device element is scheduled to be produced, a step to inlay an insulator in the groove, the insulator filling the groove, and a step to anneal the insulator whereby the strain which would have been produced in the absence of the thermal strain absorbing layer along the upper edges of the mesa-shaped portion during the annealing, is absorbed by the thermal strain absorbing layer present over the upper surface of the mesa-shaped portion.

The concept of the present invention is to interleave a thermal strain absorbing layer between the top surface of a semiconductor substrate and an insulating layer of which a part is scheduled to become a buried insulating layer, for the purpose to allow the thermal strain absorbing layer to absorb strains which may otherwise occur due to an annealing process and to prevent damages which may otherwise be produced by irradiation of ion beams, from being produced.

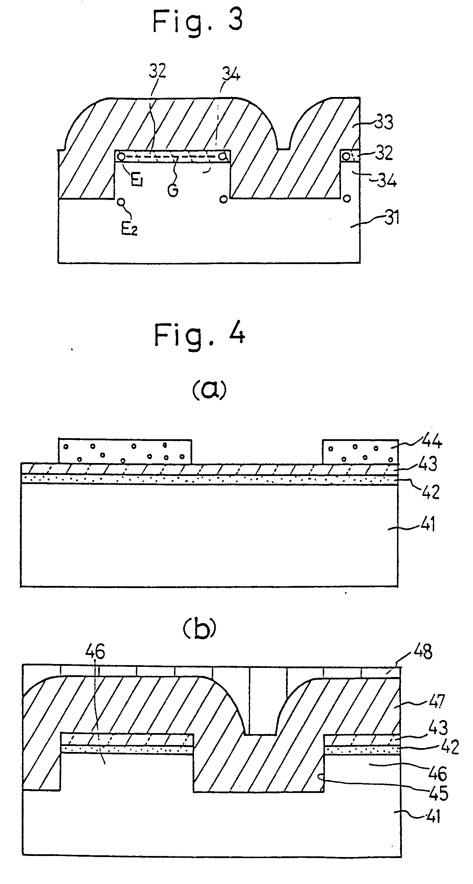

Fig. 3 shows the cross-sectional view of a semiconductor device produced employing a method for the production of a semiconductor device in accordance with the present invention. Since a thermal strain absorbing layer 32 is interleaved between the top surface of a semiconductor layer 31 and an insulator layer 33 except for the area which is scheduled to become a buried insulating layer, strains $E_1$ occur along the edges of the thermal strain absorbing layer 32 rather than along the top edges of the element fabrication areas of the semiconductor substrate 31, during an annealing process which is carried out for the purpose to unify the density of the insulating layer 33. During a dry etching process which is carried out to remove a portion of the insulating layer 33, damages G are produced in the thermal strain absorbing layer 32 rather than in the semiconductor substrate 31. As a result, the portions of the semiconductor substrate 31 in which elements are scheduled to be produced are successfully protected from potential strains and damages, resultantly enabling the characteristics of the elements to be enhanced. Since the strains $E_1$ do not occur in the semiconductor substrate 31 and since the magnitude of stress which may cause strains $E_2$ is limited, the amount of strains $E_2$ which occurs along the bottom edges of the element fabrication areas 34 of the semiconductor substrate surrounded by the buried insulating layers is successfully decreased.

The requirements for the thermal strain absorbing layer are (a) that the material will have to be stable from chemical aspects under the annealing temperature of approximately 900°C or higher and (b) that the material readily absorbs strains. Exemplary materials satisfying these requirements are polycrystalline silicone (Si), molybdenum silicide (MoSi$_2$), tungsten silicide (WSi$_2$), titanium silicide (TiSi$_2$) and tantalum silicide (TaSi$_2$).

Silicon dioxide (SiO$_2$), silicon nitride (Si$_3$N$_4$) and aluminium oxide (Al$_2$O$_3$) can be selected as the material of the buried insulating layer.

Not only silicon (Si), but also any of the compound semiconductors including gallium-arsenide (GaAs), indium-phosphide (InP) et al. can be selected as the material of the semiconductor substrate.

To achieve the foregoing second object, a method for the production of a semiconductor device in accordance with the other embodiment of the present invention comprises, in addition to the steps specified above for the method for the production of a semiconductor device in accordance with the present invention, a step to produce a conductive layer on the thermal strain absorbing layer and on the buried insulating layer and a step to pattern the conductive layer to a shape corresponding to the gate electrode and some of the conductive wires.

Materials selected as a material of the conductive layer are molybdenum silicide (MoSi$_2$), tungsten silicide (WSi$_2$), titanium silicide (TiSi$_2$), tantalum silicide (TaSi$_2$) and polycrystalline silicon (Si).

The present invention, together with its various features and advantages, can be readily understood from the following more detailed description presented in conjunction with the following drawings.

Fig. 1 is a cross-sectional view of a silicon (Si) substrate showing the position after the completion of the local oxidation process, the figure being shown for the purpose to point out drawbacks involved with the local oxidation process.

Figs. 2(a), 2(b), 2(c), 2(d), 2(e) and 2(f) are cross-sectional views fo silicon (Si) substrates, each of which shows the position after the completion of each of the major steps of a method for the production of a buried insulating layer which functions as isolation, available in the prior art.

Fig. 3 is a cross-sectional view of a semiconductor device produced employing a method for the production of a semiconductor device in accordance with the present invention.

Figs. 4(a), 4(b), 4(c), 4(d) and 4(e) are cross-sectional views of silicon (Si) substrates, each of which shows the position after the completion of each of the major steps of a method for the production of a semiconductor device in accordance with one embodiment of the present invention.

Figs. 5(a), 5(b) and 5(c) are cross-sectional views of silicon (Si) substrates, each of which shows the position after the completion of each of the major steps of a method for the production of a semiconductor device in accordance with the other embodiment of the present invention.

Fig. 6 is a cross-sectional view of a complementary MOS (C—MOS) semiconductor device produced employing a method for the production of a semiconductor device in accordance with a third embodiment of the present invention.

Figs. 7(a) and 7(b) are cross-sectional views, of which the former and the latter respectively show an intermediate position of and the position after the completion of a process for the production of a 1-transistor and 1-capacitor type dynamic random access memory cell in accordance with a fourth embodiment of the present invention.

Figs. 8(a) and 8(b) are cross-sectional views, of which the former and the latter respectively show an intermediate position of and the position after the completion of a process for the production of a bipolar type integrated circuit device in accordance with a fifth embodiment of the present invention.

In the following description, each embodiment in accordance with the present invention will be presented, on the assumption that FET-s are produced in a silicon substrate, such FET-s being isolated from one another by buried insulating layers, each of which surrounds each of such FET-s.

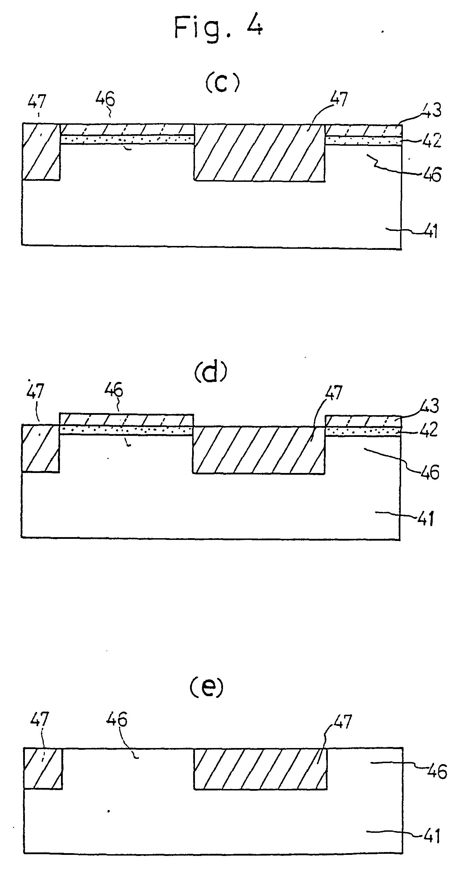

The first embodiment is a method for the production of a semiconductor device having a plurality of FET-s, each of which is fabricated in an element fabrication area of a silicon (Si) substrate surrounded by a buried insulating layer, wherein an improvement is realized in which a thermal strain absorbing layer of polycrystalline silicon (Si) is interleaved between the substrate and the insulating layer for the purpose to cause the polycrystalline silicon (Si) layer to absorb potential strains and damages which may otherwise occur in the silicon (Si) substrate. This embodiment will be presented, referring to Figs. 4(a), 4(b), 4(c), 4(d) and 4(e).

Referring to Fig. 4(a), the top surface of a silicon (Si) substrate 41 is oxidized to produce a silicon dioxide ($SiO_2$) layer 42 having a thickness of 500Å (0,05 μm), before a polycrystalline silicon (Si) layer 43 having a thickness of 1000Å (0,1 μm) is grown on the silicon dioxide ($SiO_2$) layer 42. The function of the silicon dioxide ($SiO_2$) layer 42 is to make it easy to remove the polycrystalline silicon (Si) layer 43 in a later step. In other words, it functions to solve the difficulty in removing the polycrystalline silicon (Si) layer 43 which is produced directly on the silicon (Si) substrate 41 which is of course the material identical to the layer. The function of the polycrystalline silicon (Si) layer 43 is to absorb strains and damages. Therefore, it is needless to emphasize that this layer 43 can be replaced by a molybdenum silicide ($MoSi_2$) layer, a tungsten silicide ($WSi_2$) layer, a titanium silicide ($TiSi_2$) layer, a tantalum silicide ($TaSi_2$) layer or the like, insofar as the annealing temperature range is 900 through 1100°C. This is because these materials are stable from the chemical viewpoint in the foregoing temperature range and readily absorb strains. A photoresist layer 44 is produced on the surface of the polycrystalline silicon (Si) layer 43, before a patterning process is applied to the photoresist layer 44 for the purpose to produce grooves along the area corresponding to the area in which a buried insulating layer is produced.

Referring to Fig. 4(b), the patterned photoresist layer 44 functions as a mask during a parallel plate type reactive ion etching process applied to the substrate for the purpose to partly remove the polycrystalline silicon (Si) layer 43, the silicon (Si) substrate 41 for the ultimate purpose to produce grooves 45 having the depth of 6500Å (0,65 μm) in the silicon (Si) substrate 41. The carbon fluoride ($CF_4$) gas containing oxygen ($O_2$) of 5% is employed as the reactive gas and the etching rate of 200Å (0,02 μm)/min is realized at the pressure of $5 \times 10^{-3}$ Torr (0,67 Pa). After the photoresist layer 44 is entirely removed, a low pressure chemical vapor deposition process is employed to grow a silicon dioxide ($SiO_2$) layer 47 having

the thickness of 8000Å (0,8 μm) which entirely covers the top surface of the substrate 41. Thereafter, the substrate is applied to an annealing process for 20 minutes in nitrogen ($N_2$) gas at the temperature of 1000°C for the purpose to unify the density of the silicon dioxide ($SiO_2$) layer 47. Albeit strains may occur in the polycrystalline silicon (Si) layer 43 during this process, the entire portion of the silicon (Si) substrate 41 is maintained free from strains. In other words, potential strains which might occur along the edges of the element fabrication area 46 of the silicon (Si) substrate 41 surrounded by the buried insulating layer 47, are absorbed by the polycrystalline silicon (Si) layer 43. The top surface of the silicon dioxide ($SiO_2$) layer 47 is coated by a photoresist layer 48 of e.g. AZ1350J produced and marketed by Shipley Company Inc. of the U.S.A. and the top surface of the photoresist layer 48 becomes flat.

Referring to Fig. 4(c), a dry etching process is applied to the substrate, until the top surface of the polycrystalline silicon (Si) layer 43 is exposed. The argon (Ar) gas at the pressure of $7 \times 10^{-4}$ Torr (0,093 Pa) is employed and the etching rate of 500Å (0,05 μm)/min is realized. Albeit damages may occur in the polycrystalline silicon (Si) layer 43, during this process the entire portion of the silicon (Si) substrate 41 is protected from damages. This means that potential damages which might otherwise be produced along the edges of the element fabrication area 46 of the silicon (Si) substrate 41 surrounded by the buried insulating layer 47, are absorbed by the polycrystalline silicon (Si) layer 43.

Referring to Fig. 4(d), a dry etching process is applied to the substrate to exclusively remove the upper portion of the silicon dioxide ($SiO_2$) layer 47 by a depth corresponding to the thickness of the polycrystalline silicon (Si) layer 43. The trifluoromethane ($CHF_3$) gas at the pressure of 0.05 Torr (6,7 Pa) is employed and the etching rate of 800Å (0,08 μm)/min is realized.

Referring to Fig. 4(e), a plasma etching process employing carbon fluoride ($CF_4$) gas containing 5% of oxygen ($O_2$) at the pressure of 1 (one) Torr (133 Pa) is applied to the substrate to remove the polycrystalline silicon (Si) layer 43 at the etching rate of 500Å (0,05 μm)/min. Thereafter, the hydrogen fluoride (HF) solution is caused to contact the surface of the substrate to remove the silicon dioxide ($SiO_2$) layer 42 and the top portion of the silicon dioxide ($SiO_2$) layer 47, and the top surface of the silicon (Si) substrate 41 is exposed. As a result, a portion of the silicon dioxide ($SiO_2$) layer 47 is remained buried surrounding the element fabrication area 46 of the silicon (Si) substrate 41 and the buried silicon dioxide ($SiO_2$) layer 47 is allowed to function as an isolation.

The foregoing description has clarified that a method for the production of a semiconductor device having a plurality of FET-s each of which is fabricated in an element fabrication area of a silicon (Si) substrate surrounded by a buried insulating layer which functions as an isolation, wherein improvements are realized to prohibit a high temperature process which is carried out to unify the density of the insulating layer, from causing strains to occur at the corners of the element fabrication area of the silicon (Si) substrate surrounded by the buried insulating layer and to prohibit the dry etching process which is carried out to remove the insulating layer from the area except for the buried insulating layer, from producing damages on the surface of the element fabrication area of the silicon (Si) substrate surrounded by the buried insulating layer, is successfully provided. As a result, in accordance with the present embodiment, it is possible to produce a semiconductor device having a high quality.

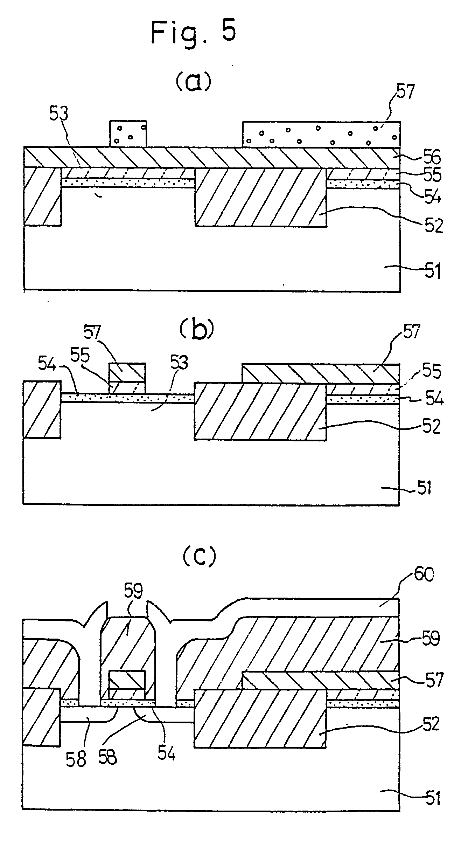

The second embodiment which is an extension of the foregoing embodiment, is a method for the production of a semiconductor device in accordance with the first embodiment, wherein the polycrystalline silicon (Si) layer of which the original function is to absorb thermal strains, is further employed for the production of electrodes of gates and/or some of the metal wirings for the purpose to simplify the production steps thereof. This embodiment will be presented, referring to Figs. 5(a), 5(b) and 5(c).

The steps described below will follow the step of the foregoing embodiment presented with reference to Fig. 4(c).

Referring to Fig. 5(a), a p type silicon (Si) substrate, a buried silicon dioxide ($SiO_2$) layer and a region of the substrate in which elements are scheduled to be produced (an element fabrication region) are designated as 51, 52 and 53 respectively. A silicon dioxide ($SiO_2$) layer and a polycrystalline silicon (Si) layer are designated as 54 and 55 respectively. Referring to the figure, a molybdenum silicide ($MoSi_2$) layer 56 having the thickness of 3000Å (0.3 µm) is produced on the patterned polycrystalline silicon (Si) layer 55 and the remained portion of the silicon dioxide ($SiO_2$) layer 54. Thereafter, a photoresist pattern 57 which corresponds to those of the gates and some of the wirings, is produced on the molybdenum silicide ($MoSi_2$) layer 56. Since the requirements for a material of the metal layer which is scheduled to be a metal wiring are the chemical stability and a less amount of electrical resistance, any of the materials presented above as the materials for the thermal strain absorbing layer is qualified as a material of the foregoing metal layer.

Referring to Fig. 5(b), the photoresist pattern 57 functions as a mask for a dry etching process which is applied to the substrate. The carbon fluoride ($CF_4$) gas containing oxygen ($O_2$) of 5% is employed at the pressure of $5 \times 10^{-3}$ Torr (0,67 Pa) and the etching rate of 200Å (0,02 µm)/min is realized. Since this dry etching process does not proceed into a silicon oxide ($SiO_2$) layer, it is possible to simultaneously pattern the gate electrodes and the metal wirings employing a single mask.

Referring to Fig. 5(c), a series of ordinary steps available in the prior art is employed for the production of sources and drains 58, an inter-layer insulating layer 59, an upper layer wiring 60 et al. for the ultimate purpose to produce a MOS IC. The right portion of Fig. 5(c) shows a cross-sectional view of a MOS transistor, the cross-sectional view showing a cross-section which is parallel to the direction in which the gate electrode extends. In other words, the source and drain (not shown) of the MOS transistor are located in the direction perpendicular to the page.

The foregoing description has clarified that a method for the production of a semiconductor device in accordance with the first embodiment is successfully expanded to a second embodiment, wherein the polycrystalline silicon (Si) layer of which the original function is to absorb thermal strains is further employed for the production of gate electrodes and/or some of the metal wirings. As a result, in accordance with the present second embodiment it is possible to simply the production steps of a method for the production of a semiconductor device.

Albeit the present invention has been described with reference to a specific embodiment, this description is not meant to be construed in a limiting sense. Various modifications of the described embodiments, as well as other embodiments of this invention, will become apparent to persons skilled in the art upon reference to the description of the present invention. It is therefore contemplated that the appended claims will cover any such modifications or embodiments as fall within the true scope of this invention.

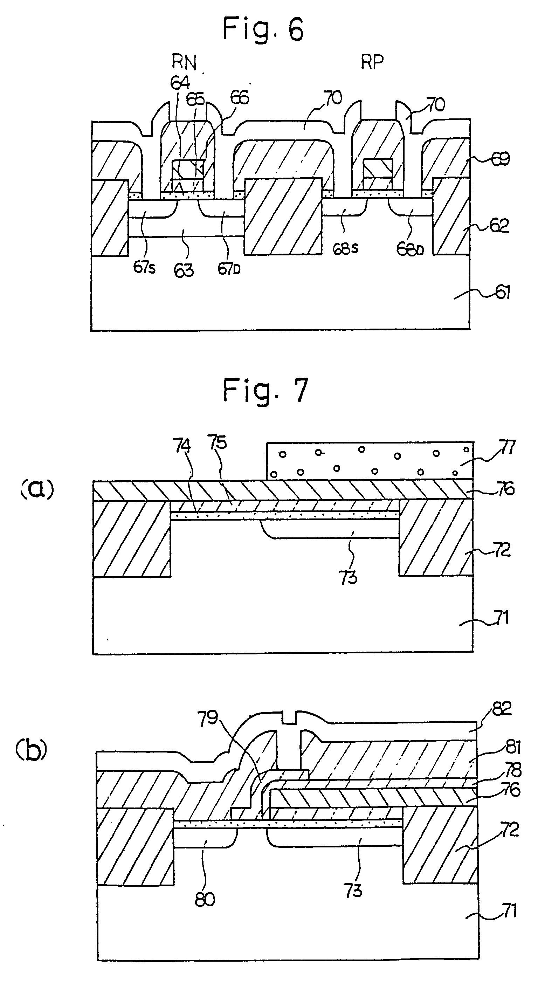

Fig. 6 shows a cross-sectional view of a complementary MOS (C—MOS) semiconductor device produced employing a method for the production of a semiconductor device in accordance with the present invention.

Referring to Fig. 6, regions RN and RP respectively show an n-channel type MOS transistor region and a p-channel type MOS transistor region. An n-type silicon (Si) substrate, a buried silicon dioxide ($SiO_2$) layer and a p-well are designated as 61, 62 and 63 respectively. A gate insulating layer produced of silicon dioxide ($SiO_2$) is designated as 64. A gate electrode is fabricated with a double layer consisting of a polycrystalline silicon (Si) layer 65 and a molybdenum silicide ($MoSi_2$) layer 66. The source region and the drain region of the n-channel type MOS transistor are designated as 67S and 67D respectively, and the source region and the drain region of the p-channel type MOS transistor are designated as 68S and 68D respectively. An insulating layer produced of silicon dioxide ($SiO_2$) or phosphosilicate glass is designated as 69, and 70 is a metal wiring layer.

The steps for the production of such a C—MOS semiconductor device as illustrated in Fig. 6 will be described below. The first step is to employ a method available in the prior art to introduce an acceptor impurity into the n type silicon (Si) substrate 61 to produce the p-well region 63, before the silicon dioxide ($SiO_2$) layer 64 and the polycrystalline silicon (Si) layer 65 are grown on the substrate 61.

Some steps which are identical to those which are described with reference to Fig. 4 or Fig. 5 above follow. In other words, the polycrystalline silicon (Si) layer 65 and the silicon dioxide (SiO$_2$) layer 64 are selectively removed by etching processes, and a groove is produced in the substrate 61, before the insulating material (SiO$_2$) 62 is inlaid in the groove. It is essential that at least a part of the groove is produced in the region where the p-n junction separating the p-well 63 and the substrate 61 is exposed to the surface of the substrate 61, so that the p-n junction separating the p-well 63 and the substrate 61 contacts the buried silicon dioxide (SiO$_2$) layer 62 inlaid in the groove.

The next step is to produce the molybdenum silicide (MoSI$_2$) layer 66 on the foregoing polycrystalline silicon (Si) layer 65 and the buried silicon dioxide (SiO$_2$) layer 62, before a double layer consisting of the molybdenum silicide (MoSi$_2$) layer 66 and the polycrystalline silicon (Si) layer 65 is selectively removed and the gate electrode and wirings are produced.

The next steps are to introduce a donor impurity and an acceptor impurity respectively to the p-well region and to substrate 61 respectively for the purpose to produce the n$^+$ type source and drain regions 67S and 67D and to produce the p$^+$ type source and drain regions 68S and 68D. During these steps the gate electrode functions as a mask. Thereafter, the insulating layer 69 is produced, openings are produced for the connection of sources, drains and gates, and the metal wiring layer 70 is produced.

Figs. 7(a) and 7(b) show a cross-sectional view of a 1-transistor and 1-capacitor type dynamic random access memory (D—RAM) cell produced employing a method for the production of a semiconductor device in accordance with the present invention.

The D—RAM cell in accordance with this embodiment is provided with a thermal strain absorbing layer of a polycrystalline silicone (Si) layer which is one of the electrodes of the capacitor and with a silicon dioxide (SiO$_2$) layer which is interleaved between the thermal strain absorbing layer and a substrate and which functions as a dielectric layer for the capacitor and functions as a gate insulating layer for a MOS transistor which functions as the transfer gate of the D—RAM cell.

Referring to Fig. 7(a), an n$^+$ type region 73 is produced on a selected area of the element fabrication region surrounded by a buried silicon dioxide (SiO$_2$) layer 72 which is inlaid along the surface of a p type silicon substrate 71. Thereafter, a silicon dioxide (SiO$_2$) layer 74 and a polycrystalline silicon (Si) layer 75 are produced on the element fabrication region. In the same manner as in the case of the previous embodiment, the polycrystalline silicon (Si) layer 75 functions as a thermal strain absorbing layer during a process for growing the foregoing buried silicon dioxide (SiO$_2$) layer 72. The foregoing n$^+$ type region 73 is produced, before the silicon

dioxide (SiO$_2$) layer 74 is produced. After a molybdenum silicide (MoSi$_2$) layer 76 is produced to cover the polycrystalline silicon (Si) layer 75 and the buried silicon dioxide (SiO$_2$) layer 72, a photoresist layer 77 is produced to selectively cover the molybdenum silicide (MoSi$_2$) layer 76.

Referring to Fig. 7(b), the next step is to selectively remove the molybdenum silicide (MoSi$_2$) layer 76 and the polycrystalline silicon (Si) layer 75, employing the photoresist layer 77 as a mask. After the photoresist layer 77 is removed, the surfaces of the molybdenum silicide (MoSi$_2$) layer 76 and the polycrystalline silicon (Si) layer 75 are oxidized to be converted to an oxide layer 78.

The next step is to produce a polycrystalline silicon (Si) layer 79 which extends along the surface of the silicon dioxide (SiO$_2$) layer 74 and of the oxide layer 78 which is located on the molybdenum silicide (MoSi$_2$) layer 76, before the polycrystalline silicon (Si) layer 79 is employed as a mask for a process to introduce a donor impurity into the substrate 71 for the purpose to produce an n$^+$ type region 80.

The polycrystalline silicon (Si) layer 79 functions as a transfer gate electrode, and the n$^+$ type region 80 functions as a bit line.

Thereafter, an insulating layer 81 is produced, openings are produced for the connection of electrodes, and a metal wiring 82 which functions as a word line is produced.

The n$^+$ type region 73 functions as the other of the electrodes of the capacitor. As described earlier, the thermal strain absorbing layer 75 successfully prevents damages from being produced in the element fabrication region, thereby causing to decrease the amount of leak current in such a region and resultantly to enhance the charge holding capacity. As a result, a longer refreshment time can be realized for the memory cell produced employing a method for the production of a semiconductor device in accordance with the present invention.

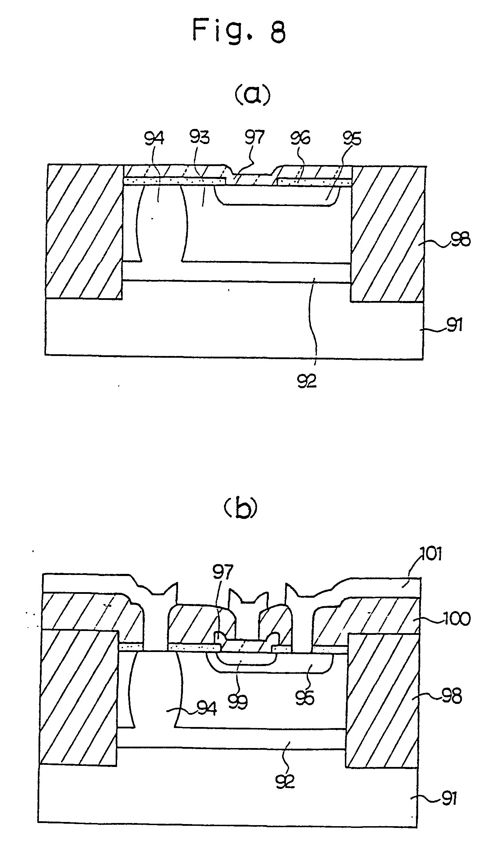

Figs. 8(a) and 8(b) show cross-sectional views, of which the former and the latter respectively show an intermediate position of and the position after the completion of a process for production of a bipolar type integrated circuit device in accordance with one embodiment of the present invention.

The bipolar type integrated circuit device in accordance with this embodiment is provided with a thermal strain absorbing layer of a polycrystalline silicon (Si) layer which functions also as an impurity source for the production of an emitter region and/or as an emitter electrode.

Referring to Fig. 8(a), an n$^+$ type collector contact region 94 and a p type base region 95 are produced in an n type silicon (Si) epitaxial layer 93 which is grown on an n$^+$ type buried layer 92 which is further grown on a p type silicon (Si) substrate 91.

Thereafter, a silicon diode (SiO$_2$) layer 96 is produced on the n type silicon (Si) epitaxial layer 93, and an opening for the production of an emitter region is produced in the silicon dioxide

($SiO_2$) layer 96, before a polycrystalline silicon (Si) layer 97 which contains phosphorus (P) is produced to cover the silicon dioxide ($SiO_2$) layer 96 and the foregoing opening.

The next step is to produce a groove which penetrates the polycrystalline silicon (Si) layer 97 to reach the silicon substrate 91, before the same process as described earlier to produce a buried silicon dioxide ($SiO_2$) layer 98 is employed.

Referring to Fig. 8(b), an $n^+$ type emitter region 99 is produced during the heat treatment carried out for the production of the buried silicon dioxide ($SiO_2$) layer 98, because phosphorus (P) is diffused from the polycrystalline silicon (Si) layer 97 into a limited portion of the p type base region 95 during the heat treatment.

Thereafter, the polycrystalline silicon (Si) layer 97 is selectively removed, an insulating layer 100 is produced, a window for an electrode is produced, and a metal wiring 101 is produced.

## Claims

1. A method for the production of a semiconductor device, comprising a step to grow a thermal strain absorbing layer (43, 55, 65, 75, 97) over the top surface of a substrate (41, 51, 61, 71, 91) comprising a semiconductor, an etching step to remove selectively the thermal strain absorbing layer (43, 55, 65, 75, 97) and produce in the exposed portion of the substrate (41, 51, 61, 71, 91) a groove (45) surrounding a mesa-shaped portion (46) of the substrate (41, 51, 61, 71, 91) where a device element is scheduled to be produced,

a step to inlay an insulator (47, 52, 62, 72, 98) in the groove (45), the insulator (47, 52, 62, 72, 98) filling the groove,

and a step to anneal the insulator (47, 52, 62, 72, 98) whereby the strain which would have been produced in the absence of the thermal strain absorbing layer (43, 55, 65, 75, 97) along the upper edges of the mesa-shaped portion (46) during the annealing, is absorbed by the thermal strain absorbing layer (43, 55, 65, 75, 97) present over the upper surface of the mesa-shaped portion (46).

2. The method for the production of a semiconductor device in accordance with claim 1, wherein the material used as a thermal strain absorbing layer (43, 55, 65, 75, 97) is a material selected from the group including polycrystalline silicon (Si), molybdenum silicide ($MoSi_2$), tungsten silicide ($WSi_2$), titanium silicide ($TiSi_2$) and tantalum silicide ($TaSi_2$).

3. The method for the production of a semiconductor device in accordance with claim 1 or 2, wherein the material used as an insulator (47, 52, 62, 72, 98) is selected from the group including silicon oxide ($SiO_2$), silicon nitride ($Si_3N_4$) and aluminium oxide ($Al_2O_3$).

4. The method for the production of a semiconductor device in accordance with any of the claims 1 to 3, wherein the material used as a semiconductor substrate (41, 51, 61, 71, 91) is a material selected from the group including silicon (Si), gallium-arsenide (GaAs) and indium-phosphide (InP).

5. The method for the production of a semiconductor device in accordance with any of the claims 1 to 4, further comprising a step to produce a metal layer (60, 70, 82, 101) on the thermal strain absorbing layer and on the insulator, and a step to pattern the metal layer (60, 70 82, 101) to a shape corresponding to electrodes and metal wires.

6. The method for the production of a semiconductor device in accordance with claim 5, wherein the material used as a metal layer (60, 70, 82, 101) is a material selected from the group including molybdenum silicide ($MoSi_2$), tungsten silicide ($WSi_2$), titanium silicide ($TiSi_2$), tantalum silicide ($TaSi_2$) and polycrystalline silicon (Si).

## Patentansprüche

1. Verfahren zur Herstellung einer Halbleiteranordnung umfassend

eine Schritt zum Aufwachsen einer thermische Spannungen absorbierenden Schicht (43, 55, 65, 75, 97) über der oberen Oberflähe eines Substrats (41, 51, 61, 71, 91), das einen Halbleiter aufweist,

einen Ätzschritt, um die thermische Spannungen absorbierende Schicht (43, 55, 65, 75, 97) selektiv zu entfernen und in dem freiliegenden Bereich des Substrats (41, 51, 61, 71, 91) eine Nut (45) zu erzeugen, die einen mesaförmigen Bereich (46) des Substrats (41, 51, 61, 71, 91) umgibt, wo ein Anordnungselement zu erzeugen geplant ist,

einen Schritt zum Einlegen eines Isolators (47, 52, 62, 72, 98) in die Nut (45), wobei der Isolator (47, 52, 62, 72, 98) die Nut füllt,

und einen Schritt zum Wärmebehandeln des Isolators (47, 52, 62, 72, 98), so daß die Spannung, die in Abwesenheit der thermische Spannungen absorbierenden Schicht (43, 55, 65, 75, 97) längs der oberen Kanten des mesaförmigen Bereiches (46) während der Wärmebehandlung erzeugt worden wäre, durch die thermischee Spannungen absorbierende Schicht (43, 55, 65, 75, 97) absorbiert wird, die über der oberen Oberfläche des mesaförmigen Bereiches (46) vorhanden ist.

2. Verfahren zur Herstellung eines Halbleiteranordnung nach Anspruch 1, wobei das Material, das als thermische Spannung absorbierende Schicht (43, 55, 65, 75, 97) verwendet wird, ein Material ist, das aus der Gruppe gewählt wird, die polykristallines Silicium (Si), Molybdänsilicid ($MoSi_2$), Wolframsilicid ($WSi_2$), Titansilicid ($TiSi_2$) und Tantalsilicid ($TaSi_2$) umfaßt.

3. Verfahren zur Herstellung einer Halbleiteranordnung nach Anspruch 1 oder 2, wobei das Material, das als Isolator (47, 52, 62, 72, 98) verwendet wird, aus der Gruppe gewählt wird, die Siliciumoxid ($SiO_2$), Siliciumnitrit ($Si_3N_4$) und Aluminiumoxid ($Al_2O_3$) umfaßt.

4. Verfahren zur Herstellung einer Halbleiteranordnung nach einem der Ansprüche 1 bis 3, wobei das Material, das als Halbleitersubstrat (41, 51, 61, 71, 91) verwendet wird, ein Material ist, das aus der Gruppe gewählt wird, die Silicium (Si), Galliumarsenid (GaAs) und Indiumphosphid (InP) umfaßt.

5. Verfahren zur Herstellung einer Halbleiteranordnung nach einem der Ansprüche 1 bis 4, ferner umfassend einen Schritt zur Erzeugung einer Metallschicht (60, 70, 82, 101) auf der thermische Spannungen absorbierenden Schicht und auf dem Isolator, sowie einen Schritt zum Strukturieren der Metallschicht (60, 70, 82, 101) in eine Gestalt, die Elektroden und Metalldrähten entspricht.

6. Verfahren zur Herstellung einer Halbleiteranordnung nach Anspruch 5, wobei das Material, das als Metallschicht (60, 70, 82, 101) verwendet wird, ein Material ist, das aus der Gruppe gewäht wird, die Molybdänsilicid (MoSi₂), Wolframsilicid (WSi₂), Titansilicid (TiSi₂), Tantalsilicid (TaSi₂) und polykristallines Silicium (Si) umfaßt.

**Revendications**

1. Procédé de production d'un dispositif semi-conducteur comportant une phase de croissance d'une couche d'absorption de contraintes thermiques (43, 55, 65, 75, 97) au-dessus de la surface supérieure d'un substrat (41, 51, 61, 71, 91) consistant en un semi-conducteur, une phase de gravure pour éliminer sélectivement la couche d'absorption de contraintes thermiques (43, 55, 65, 75, 97) et pour produire dans la partie exposée du substrat (41, 51, 61, 71, 91), une rainure (45) entourant une partie (46) en forme de tablette du substrat (41, 51, 61, 71, 91) dans laquelle il est prévu qu'un élément du dispositif soit introduit, une phase d'encastrement d'un isolant (47, 52, 62, 72, 98) dans la rainure (45), l'isolant (47, 52, 62, 72, 98) remplissant la rainure, et une phase de recuit de l'isolant (47, 52, 62, 72, 98) par laquelle les contraintes qui auraient pu être produites en l'absence de la couche d'absorption de contraintes thermiques (43, 55, 65, 75, 97) le long des bords supérieurs de la partie (46) en forme de tablette pendant le recuit sont absorbées par la couche d'absorption de contraintes thermiques (43, 55, 65, 75, 97) présente sur la surface supérieure de la partie (46) en forme de tablette.

2. Procédé de production d'un dispositif semi-conducteur selon la revendication 1, dans lequel la matière utilisée comme une couche d'absorption de contraintes thermiques (43, 55, 65, 75, 97) est une matière choisie dans le groupe comprenant le silicium polycristallin (Si), le siliciure de molybdène (MoSi₂), le siliciure de tungstène (WSi₂), le siliciure de titane (TiSi₂) et le siliciure de tantale (TaSi₂).

3. Procédé de production d'un dispositif semi-conducteur selon la revendication 1 ou 2, dans lequel la matière utilisée comme un isolant (47, 52, 62, 72, 98) est choisie dans le groupe comprenant l'oxyde de silicium (SiO₂), le nitrure de silicium (Si₃N₄) et l'oxyde d'aluminium (Al₂O₃).

4. Procédé de production d'un dispositif semi-conducteur selon l'une quelconque des revendications 1 à 3, dans lequel la matière utilisée comme un substrat semi-conducteur (41, 51, 61, 71, 91) est une matière choisie dans le groupe comprenant le silicium (Si), l'arséniure de gallium (GaAs) et l'indium-phosphore (InP).

5. Procédé de production d'un dispositif semi-conducteur selon l'une quelconque des revendications 1 à 4, comportant en outre une phase de production d'une couche métallique (60, 70, 82, 101) sur la couche d'absorption de contraintes thermiques et sur l'isolant et une phase de mise en forme de la couche métallique (60, 70, 82, 101) dans une forme correspondant aux électrodes et à des conducteurs métalliques.

6. Procédé de production d'un dispositif semi-conducteur selon la revendication 5, dans lequel la matière utilisée comme une couche métallique (60, 70, 82, 101) est une matière choisie dans le groupe comprenant le siliciure de molybdène (MoSi₂), le siliciure de tungstène (WSi₂), le siliciure de titane (TiSi₂), le siliciure de tantale (TaSi₂) et le silicium polycristallin (Si).

# Fig. 1

# Fig. 2

## (a)

## (b)

# Fig. 2

(c)

(d)

(e)

(f)

# Fig. 3

# Fig. 4

## (a)

## (b)

# Fig. 4

## (c)

## (d)

## (e)

4

# Fig. 5

## (a)

## (b)

## (c)

# Fig. 6

RN                    RP

# Fig. 7

(a)

(b)

# Fig. 8

## (a)

## (b)